# EUROPEAN PATENT APPLICATION

(11) **EP 2 736 314 A2**
(43) Date of publication of application: **28.05.2014**
(21) Application number: 13190504.4
(22) Date of filing: 28.10.2013
(51) Int. Cl.: H05K 7/14

(54) **Electronic device and electronic device system**

(30) Priority: 26.11.2012 JP 2012257256
(71) Applicant: FUJITSU LIMITED, Kawasaki-shi, Kanagawa 211-8588 (JP)
(72) Inventor: Aoki, Tomoka, Kanagawa, 211-8588 (JP); Yamanaka, Ryoichiro, Kanagawa, 211-8588 (JP); Aoki, Kenji, Kanagawa, 211-8588 (JP)
(74) Representative: HOFFMANN EITLE

(57) **Abstract**

An electronic device includes a power supply line configured to supply power to a mechanical section within a case and a connection terminal coupled to the power supply line, wherein the connection terminal is disposed to be opposed to a power exchange terminal of another electronic device disposed on one side surface of the case and engaged with the power exchange terminal to perform a power exchange.

## Description

### FIELD

The embodiments discussed herein are related to an electronic device and an electronic device system.

### BACKGROUND

In an electronic device such as, for example, an information processing unit, there is a method in which a plurality of power supply units are installed in order to secure the redundancy of the electric power, and the power is supplied from remaining power supply units when there is a failure in the power supply unit that is being used.

However, it is not desirable to dispose a plurality of power supply units within the electronic device to secure the redundancy of the power since the manufacturing costs are increased and unnecessary power is consumed. Meanwhile, if only one power supply unit is provided in the electronic device, the electronic device becomes unavailable when the power supply unit being used in the electronic device breaks down. Therefore, in a system provided with a plurality electronic devices on a rack, a power supplying path may be provided to supply the power between each case on behalf of the broken power supply unit. However, if, for example, the usage of cables for the power supplying path increases, the connection of the cables becomes complicated when the electronic devices are installed on the rack and the current efficiency deteriorates according to the increased length of the cables.

### SUMMARY

According to an aspect of the present disclosure, there is provided an electronic device including a power supply line configured to supply power to a mechanical section within a case and a connection terminal coupled to the power supply line, wherein the connection terminal is disposed to be opposed to a power exchange terminal of another electronic device disposed on one side surface of the case and engaged with the power exchange terminal to perform a power exchange.

The object and advantages of the disclosure will be realized and attained by means of the elements and combinations particularly pointed out in the claims. It is to be understood that both the foregoing general description and the following detailed description are exemplary and explanatory and are not restirctive of the disclosure, as claimed.

### BRIEF DESCRIPTION OF DRAWINGS

FIG. 1 is a view schematically illustrating a configuration of a server system according to an exemplary embodiment.

FIG. 2 is a perspective view exemplifying an appearance of an electronic device provided in a server system according to an exemplary embodiment.

FIG. 3 is a view illustrating a configuration of a PSU in a server system according to an exemplary embodiment.

FIG. 4 is a view illustrating a configuration of a dummy unit in a server system according to an exemplary embodiment.

FIG. 5 is a view for describing a processing when a break-down occurs in a PSU of a server system according to an exemplary embodiment.

FIG. 6 is a view exemplifying a method of disposing electronic devices within a rack in a server system according to an an exemplary embodiment.

FIG. 7 is a view exemplifying a method of disposing electronic devices within a rack in a server system according to an exemplary embodiment.

FIG. 8 is a partial perspective view illustrating a connection mechanism between cases in an electronic device of a server system according to an exemplary embodiment.

FIG. 9 is a perspective view illustrating a configuration of an inter-case connection mechanism in a server system in which adjacent electronic devices are not coupled, according to an exemplary embodiment.

FIG. 10 is a perspective view illustrating the configuration of the inter-case connection mechanism in the server system in which adjacent electronic devices are coupled, according to an exemplary embodiment.

FIG. 11 is a side view illustrating the configuration of the inter-case connection mechanism in which an operating lever is pressed in.

FIG. 12 is a side view illustrating the configuration of the inter-case connection mechanism in which the operating lever is in the course of being drawn out.

FIG. 13 is a side view illustrating the configuration of the inter-case connection mechanism in which the operating lever is in the course of being drawn out.

FIG. 14 is a side view illustrating the configuration of the inter-case connection mechanism in which the operating lever is drawn out.

FIG. 15 is a perspective view illustrating a portion of electronic devices in which operating levers are not drawn out according to an exemplary embodiment.

FIG. 16 is a side view of the electronic devices illustrated in FIG. 15.

FIG. 17 is a view illustrating a configuration in the vicinity of lower openings of FIG. 14 in detail.

FIG. 18 is a perspective view illustrating a portion of electronic devices in which the operating levers are drawn out.

FIG. 19 is a side view of the electronic devices illustrated in FIG. 18.

FIG. 20 is a view illustrating a modified example of a configuration of a server system according to an exemplary embodiment.

FIG. 21 is a view illustrating a configuration of PSUs of a modified configuration of a server according to an exemplary embodiment.

FIG. 22 is a view illustrating a configuration of a PSU of another modified configuration of a server according to an exemplary embodiment.

### DESCRIPTION OF EMBODIMENTS

Hereinafter, exemplary embodiments of an electronic device and an electronic device server system according to the present disclosure will be described with reference to the drawings. However, the exemplary embodiments to be described are merely illustrative and it is not intended to exclude various modified examples or applications of the techniques, which are not described in the exemplary embodiments. That is, various changes (for example, a combination of exemplary embodiments and each modified example) may be made without departing from the sprit and scope of the present disclosure. In addition, each figure is not intended to limit the constitutional elements only to those illustrated therein and may include, for example, other functions.

### (A) Server System

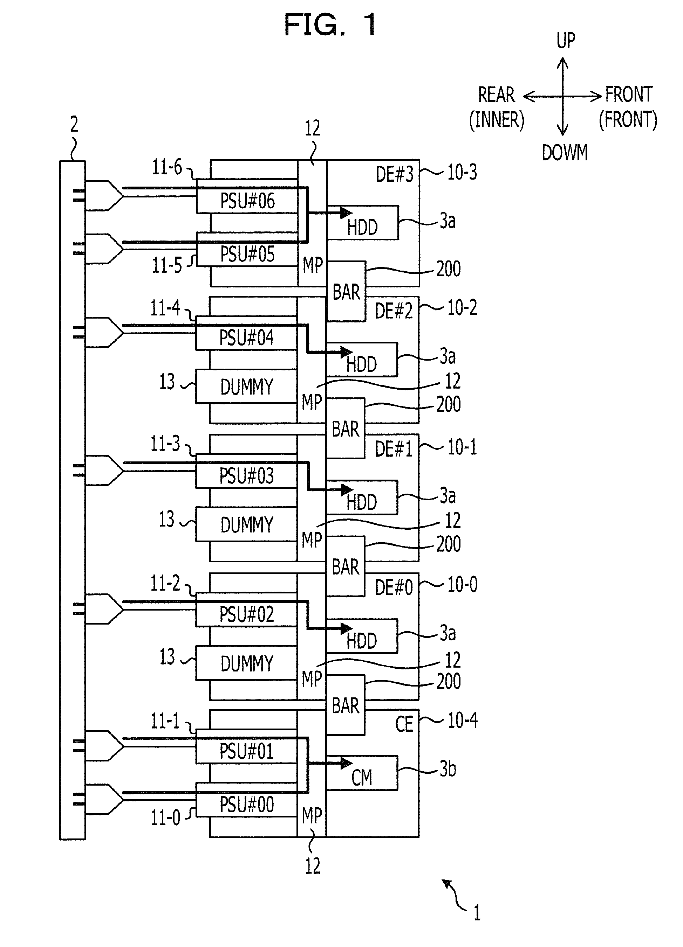

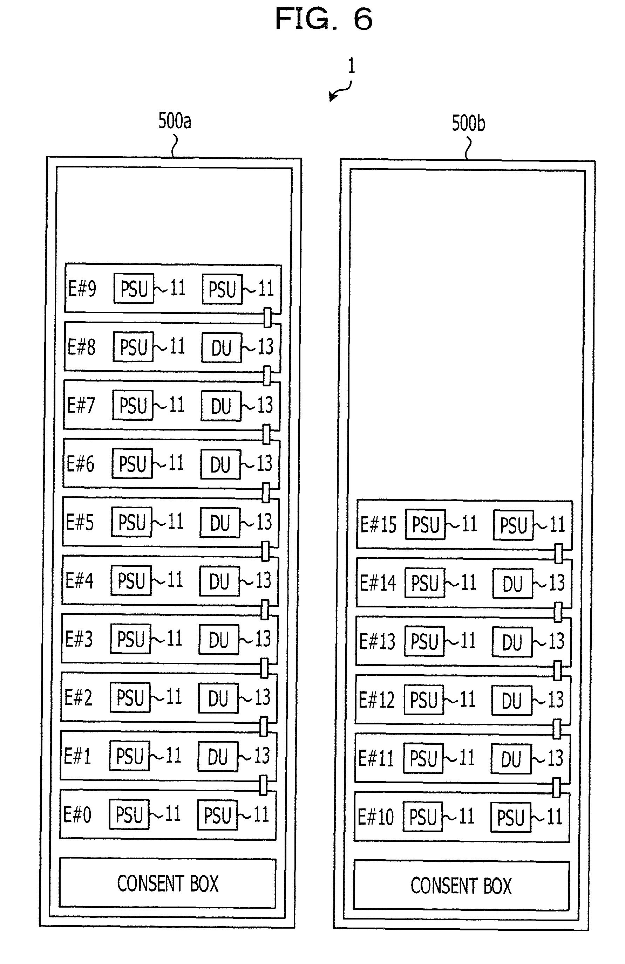

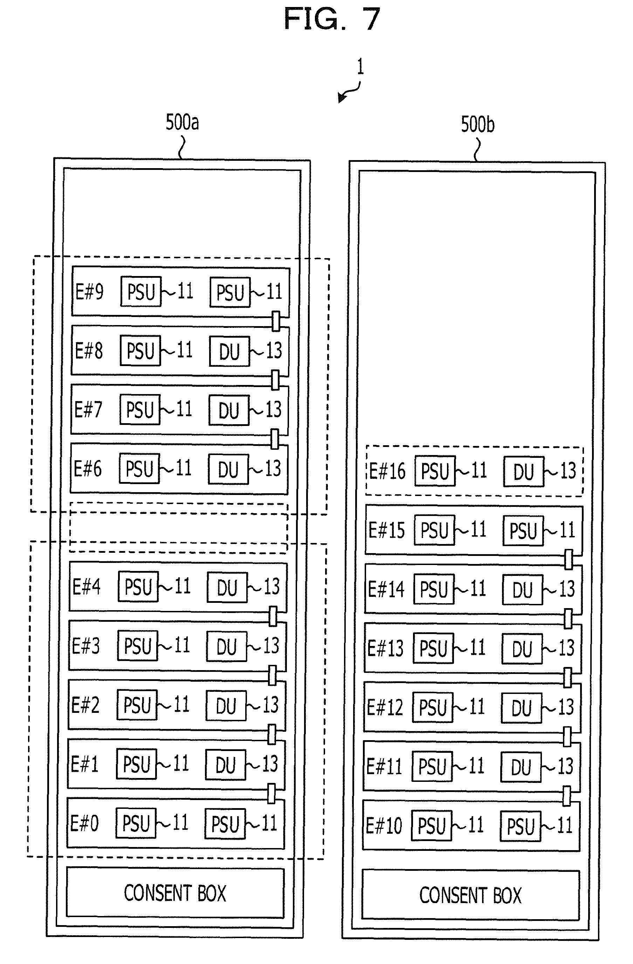

FIG. 1 is a view schematically illustrating a configuration of a server system (electronic device system) 1 according to an exemplary embodiment. The server system 1 is a server computer which is provided with a plurality of electronic devices 10-0 to 10-4 (five electronic devices in the example illustrated in FIG. 1). The electronic devices 10-0 to 10-4 have a standardized common size and are attached to racks 500a, 500b (see, *e.g*., FIGS. 6 and 7) of the server system 1 such that the electronic devices 10-0 to 10-4 may be inserted/extracted. Also, the illustration of a rack 500 is omitted, for example, in FIG. 1.

Hereinafter, as for a symbol for denoting electronic devices, symbols such as 10-0, 10-2, 10-3, or 10-4 is used when it is necessary to specify one among a plurality of electronic devices. However, when indicating an arbitrary electronic device, symbol 10 is used. Further, as for a symbol for depicting a rack, symbols 500a, 500b are used when it is necessary to specify one among a plurality of racks. However, when indicating an arbitrary rack, symbol 500 is used.

In the present server system 1, a plurality of electronic devices 10 are stacked and attached in the lengthwise direction. Hereinafter, the height direction in which a plurality of electronic devices 10 are stacked is referred to as a vertical direction. Hereinafter, descriptions will be made on an example in which the server system 1 is a storage system. The electronic device 10-4 is a controller enclosure ("CE") and the electronic devices 10-0 to 10-3 are disk enclosures ("DEs"). Hereinafter, there is a case where the electronic device 10-4 is denoted as CE 10-4. Also, the electronic devices 10-0 to 10-3 may also be denoted as DEs 10-0 to 10-3 or DE#0 to DE#3.

The CE 10-4 is provided with a controller module ("CM") 3b and controls the server system 1. The CM 3b is in charge of the entire control such as, e.g., data placement based on configuration information of RAID or parity calculation. The CM 3b performs various controls such as, for example, an access control to each HDD (Hard Disk Drive) 3a of the DE 10 according to a storage access request from an information processing unit (not illustrated).

Each of the DEs 10-0 to 10-3 is provided with an HDD 3a. The HDD 3a is a memory device (a storage device) storing data and performs a data record or readout on a storage medium (not illustrated). Also, the HDD 3a of each of the DEs 10-0 to 10-3 is coupled to the CM 3b to be capable of communicating with the CM 3b, respectively. Further, hereinafter, as for a symbol denoting an electronic device, a symbol such as 10-0, 10-2, 10-3 or 10-4 is used when it is necessary to specify one among a plurality of electronic devices. However, when indicating an arbitrary electronic device, symbol 10 is used.

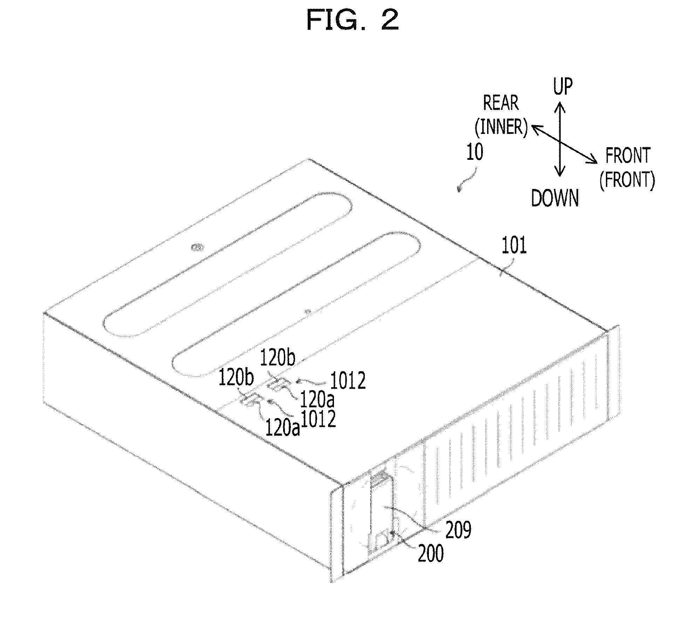

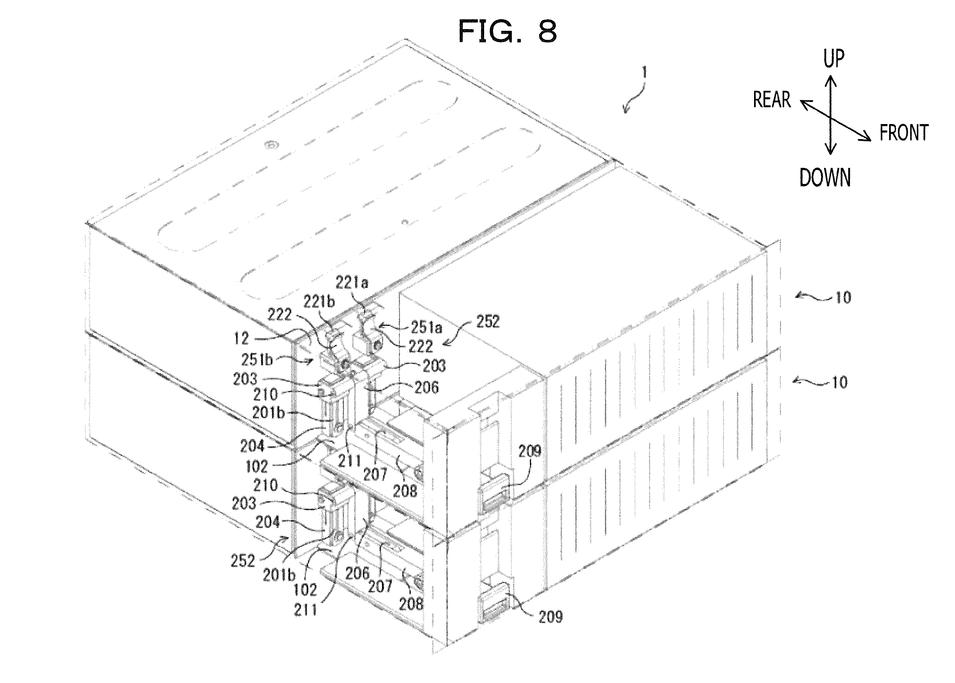

FIG. 2 is a perspective view exemplifying an appearance of the electronic device 10 which is provided in the server system 1 according to the exemplary embodiment. The electronic device 10 is provided with a case 101 of, for example, a rectangular parallelepiped. Within the case 101, the electronic device 10 includes a midplane ("MP") 12 (See, *e.g*., FIGS. 1 and 8) and a power supply unit ("PSU") 11, and further includes the HDD 3a or the CM 3b which is an example of the mechanical section (function part or function component).

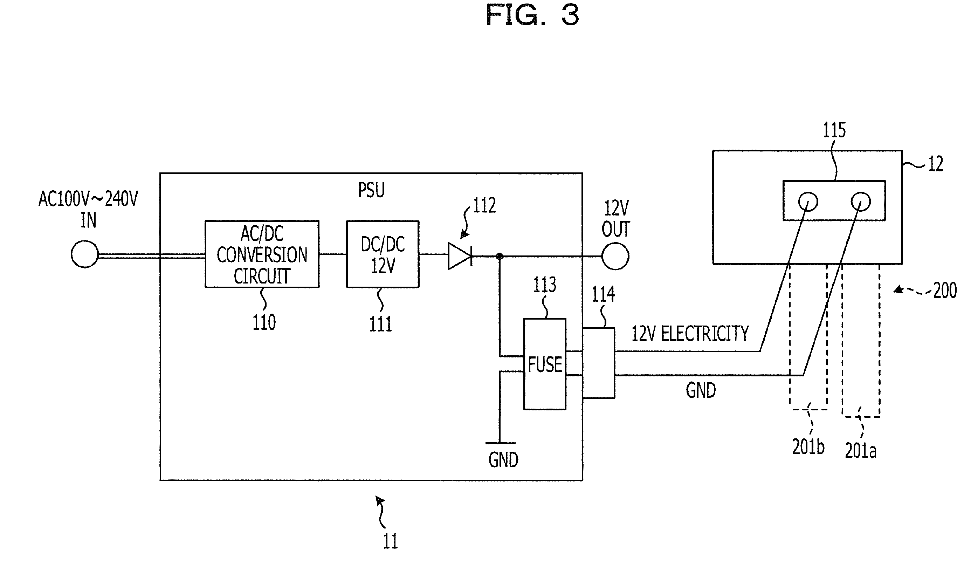

The MP 12 is a circuit board provided with a connection terminal 115 (See FIG. 3) on each of front and rear surfaces and various devices or circuits are coupled to the connection terminal 115 provided on each surface. The MP 12 interconnects, for example, the devices coupled to the front and rear surfaces. The MP 12 is provided in an erect state within the case 101 to partition the space within the case 101 by the front surface (right side of FIG. 1) and the inner surface (left side of FIG. 1).

The HDD 3a or the CM 3b is attached to the connection terminal 115 of one surface (front surface) of the MP 12 and the PSU (Power Supply Unit) 11 or a dummy unit 13, which is described later, is attached to the connection terminal 115 of the other surface (rear surface).

Hereinafter, for convenience, the normal direction of the front surface of the MP 12 is referred to as the front side and the normal direction of the rear surface of the MP 12 is referred to as the rear side. That is, for the MP 12 in the electronic device 10, the side where the HDD 3a or CM 3b is attached is the front side and the side where the PSU 11 or the dummy unit 13 is attached is the rear side (see, *e.g*., FIGS. 2 and 8).

Also, in the MP 12, an electric power supply line (not illustrated) which supplies the electric power supplied from the PSU 11 to the HDD 3a or CM 3b is wired. The electric power supply line is coupled to movable bus bars 201a, 201b of an inter-case connection mechanism 200 which is described later. In the example illustrated in FIG. 1, each of the electronic devices 10-0 to 10-2 is provided with a single PSU 11 (PSU 11-2 to 11-4) along with a dummy unit 13.

In the example illustrated in FIG. 1, DE#0 is provided with the PSU 11-2 (PSU#02) and the dummy unit 13, DE#1 is provided with the PSU 11-3 (PSU#03) and the dummy unit 13, and DE#2 is provided with the PSU 11-4 (PSU#04) and the dummy unit 13. Meanwhile, the electronic device 10-4 is provided with two PSUs 11, that is, the PSU 11-0 (PSU#00) and the PSU 11-1 (PSU#01). Similarly, the electronic device 10-3 is provided with two PSUs 11 that is, the PSU 11-5 (PSU#05) and the PSU 11-6 (PSU#06). That is, as for these electronic devices 10-3, 10-4, the PSUs 11 are provided redundantly.

Each of the PSUs 11-0 to 11-6 supplies power to each section within the same case 101. That is, each of the PSUs 11-0 to 11-6 supplies power of a predetermined voltage (for example, 12V) through the power supply line to, for example, the HDD 3a or CM 3b within each case 101. These PSU 11-0 to 11-6 have the same configuration with one another. Hereinafter, as for a symbol denoting the PSU, when it is necessary to specify one among the plurality of PSUs the symbol 11-0, 11-1, ... or 11-6 is used. However, when indicating an arbitrary PSU, the symbol 11 is used. Also, hereinafter, the PSUs 11-0 to 11-6 may be denoted as PSU#00 to PSU#06.

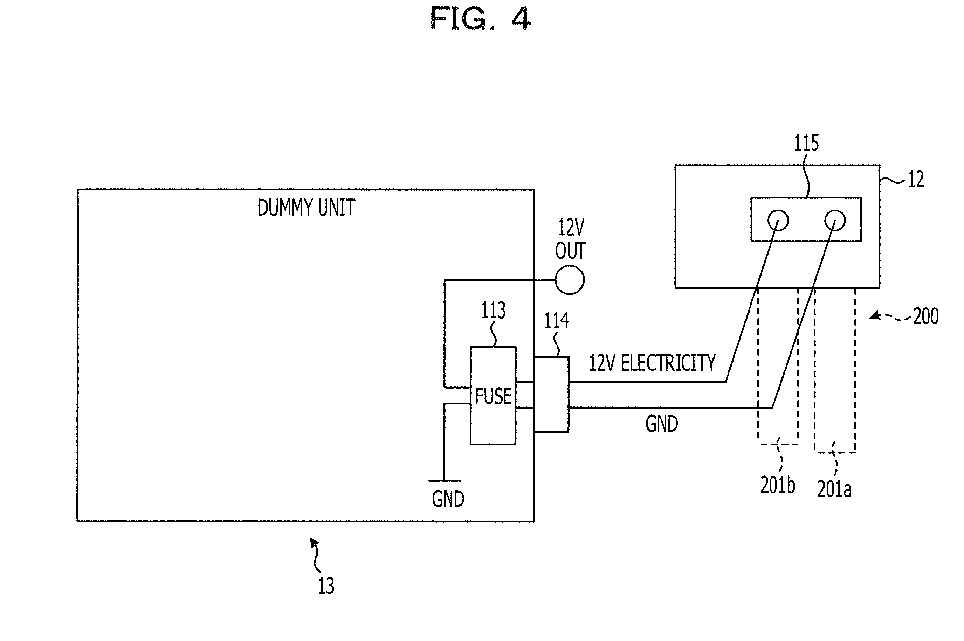

FIG. 3 is a view illustrating a configuration of a PSU 11 of the server system 1 as an example of the exemplary embodiment and FIG. 4 is a view illustrating a configuration of a dummy unit 13. As illustrated in FIG. 3, the PSU 11 is provided with an AC/DC conversion circuit 110, a DC/DC circuit 111, a rectifier circuit 112, and a fuse 113. The AC/DC conversion circuit 110 converts an alternating current supplied from an external power supply path 2 (external power: for example, AC 100V to 240V) to a direct current.

The DC/DC circuit 111 converts the direct current converted by the AC/DC conversion circuit 110 to a predetermined voltage (for example, 12V). The direct current output from the DC/DC circuit 111 is output to a connection terminal 114 through the rectifier circuit 112 and the fuse 113 and also output as a 12V OUT. The connection terminal 114 is also coupled to a GND through the fuse 113.

In the PSU 11, even when, for example, an overcurrent occurs in the PSU 11 for some reason by supplying power to the MP 12 through the fuse 113, for example, the MP 12, HDD 3a, or CM 3b may be protected. The connection terminal 114 is detachably coupled to a connection terminal 115 attached to the rear surface of the MP 12. The power supply line of 12V electricity of the PSU 11 is coupled to a movable bus bar 201b (described later) of the inter-case connection mechanism 200 in which the connection terminal 114 of the PSU 11 is coupled to the connection terminal 115 through the electric power supply line and the GND line is coupled to the movable bus bar 201a.

Also, in the PSU 11, the DC/DC circuit 111 is provided with a current balance circuit (not illustrated). The current balance circuit performs a control which maintains the current output from the connection terminal 114 constantly. The current balance circuit may be implemented by various known techniques and detailed description thereof is omitted. The dummy unit 13 is configured by omitting the AC/DC conversion circuit 110, the DC/DC circuit 111, and the rectifier circuit 112 from the PSU and provided with the fuse 113. That is, the connection terminal 114 is coupled to the 12V OUT and the GND through the fuse 113.

In the dummy unit 13, power is supplied to the MP 12 through the fuse 113 from the 12V OUT. Accordingly, even when an overcurrent occurs in the dummy unit 13 for some reason, the MP 12 or the electronic device 10 may be protected. Also, when the fuse 113 is provided in the PSU 11 or the dummy unit 13 which is configured to be detachably coupled to the MP 12, the replacement of the fuse 113 becomes easy and the work efficiency of maintenance is enhanced.

In the server system 1, each electronic device 10 is provided with at least one PSU 11. Each electronic device 10 may be operated normally with the power supplied from the PSU 11 which is installed within the electronic device 10. Therefore, in the server system 1, the electronic device 10 has a basic configuration in which one PSU 11 and one dummy unit 13 are provided as in the electronic devices 10-0 to 10-2.

Also, within the rack 500, each electronic device 10 is electrically coupled to another electronic device 10 disposed adjacent thereto by the inter-case connection mechanism 200 which is described later. In particular, as illustrated in FIG. 1, each electronic device 10 is electrically coupled to other electronic devices 10 disposed at the top and bottom sides thereof through the inter-case connection mechanisms 200, respectively. That is, in the electronic devices 10disposed adjacent thereto in the vertical direction, the 12V conductive power lines are coupled with each other and the GND lines are coupled with each other.

Accordingly, each electronic device 10 may be supplied with power from another adjacent electronic device 10. However, in a state where the PSU 11 of each electronic device 10 is operating normally, the PSU 11 of each electronic device 10 supplies power to each section within the same case 101 based on each alternating current supplied from an external power supply path 2. Accordingly, each case 101 (electronic device 10) is operated with the same electric potential and, as illustrated with arrows in FIG. 1, electrical conduction through the inter-case connection mechanisms 200 occurs between the electronic devices 10.

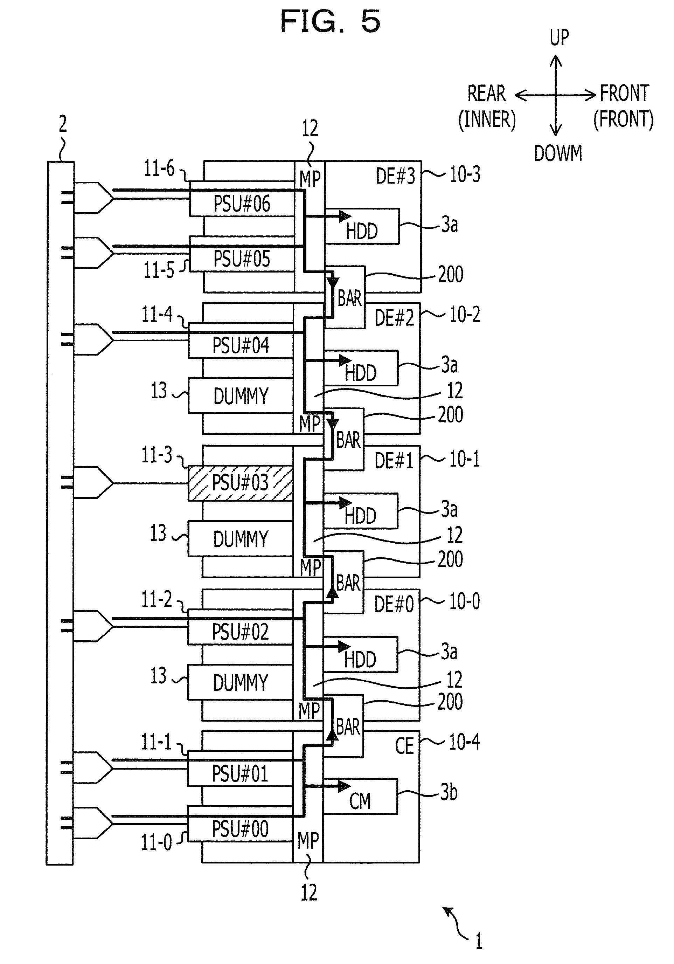

FIG. 5 is a view for describing a processing when a break-down occurs in a PSU 11 of the server system 1 as an example of the exemplary embodiment. In the example illustrated in FIG. 5, a state in which a break-down has occurred to a PSU 11-3 (PSU#03) provided in DE#1 is illustrated. As illustrated in FIG. 5, in one electronic device 10 (DE#1 in the example illustrated in FIG. 5) of the server system 1, when the electrical conduction is stopped due to the break-down of the PSU 11, a voltage drop occurs in the electronic device 10. Electronic devices 10 that are adjacent to each other in the vertical direction are electrically coupled by the inter-case connection mechanism 200.

Accordingly, the electrical conduction to DE#1 of which the voltage has dropped begins through the inter-case connection mechanisms 200 from the PSUs 11-2 and 11-4 (PSU#02, PSU#04) of the electronic devices 10 (DE#0, DE#2) adjacent to DE#1 in the vertical direction. Then, the current balance circuit (DC/DC circuit 111) of each of the PSUs 11 (#00, #01, #05, #06) of the electronic devices 10 (CE, DE#3) next to the electronic devices 10 (DE#0, DE#2) adjacent to DE#1 where broken-down PSU#03 is installed detects the variation of voltage. Accordingly, in the plurality of electronic devices 10 of the server system 1, the electrical conduction is performed through the inter-case connection mechanisms 200.

In this manner, when the PSU 11 of one electronic device 10 is broken down and power supply is stopped, the plurality of electronic devices 10 the movable bus bars 201a, 201b coupled through inter-case connection mechanisms 200adjust the current balance sequentially and resolve the entire imbalance state of the server system 1. Accordingly, power may be stably supplied to all of the electronic devices 10 including the electronic device 10 where the PSU 11 is broken down. FIGS. 6 and 7 are views exemplifying a method of disposing electronic devices 10 within a rack 500 of the server system 1 according to the exemplary embodiment.

In the examples illustrated in FIGS. 6 and 7, the server system 1 is provided with two racks 500a, 500b. Ten electronic devices 10 (E#0 to E#9) are attached to the rack 500a and six electronic device 10 (E#10 to E#15) are attached to the rack 500a. Within each of the racks 500a, 500b, each of electronic devices 10 is coupled to the other electronic devices 10 disposed adjacent thereto at the top and bottom sides through inter-case connection mechanisms 200.

Also, each of E#9 disposed at the upper-most end and E#0 disposed at the lower-most end is provided with two PSUs 11. Also in the rack 500 b, each of E#15 disposed at the upper-most end and E#10 disposed at the lower-most end is provided with two PSUs 11. That is, as for these E#0, E#9, E#10, and E#15, the PSUs is redundantly provided.

Accordingly, in each of the racks 500a, 500b, the power supplied from the redundant PSUs 11 of E#0, E#9, E#10, and E#15 at any side may be supplied to any of the electronic devices 10 through each electronic device 10 and the inter-case connection mechanisms 200. Therefore, each electronic device 10 may be operated stably. Also, as illustrated in FIG. 7, any one electronic device 10 may be extracted out of the racks 500a, 500b from a series of the plural electronic devices 10 (E#0 to E#9, E#10 to E#15) that are integrally coupled through the plurality of inter-case connection mechanisms 200, for example, for maintenance.

The example of FIG. 7 illustrates a state in which E#5 is extracted out of the rack 500a. Similarly to this, when E#5 is extracted out of the rack 500a, the plurality of electronic devices 10 (E#0 to E#9) coupled through the plurality of inter-case connection mechanisms 200 are divided into a group of electronic devices 10 (E#6 to E#9) located at the upper side of E#5 and a group of electronic devices 10 (E#0 to E#4) located at the lower side of E#5.

However, in the server system 1, each of E#9 disposed at the upper-most end of the rack 500a and E#0 disposed at the lower-most end in each group is provided with two PSUs 11. Accordingly, the redundancy of PSUs 11 may be maintained in any of the group of E#6 to E#9 and the group of E#0 to E#4 and the power supplied from the redundant PSUs 11 of E#0 or E#9 may be supplied to any electronic device 10 in each group through each electronic device 10 and the inter-case connection mechanisms 200. Therefore, each electronic device 10 may be operated stably.

Here, descriptions will be made on an example in which a new electronic device 10 (E#16) is added to the rack 500b illustrated in FIG. 7 in a state in which the server system 1 is operated, that is, in an activated state. However, the newly added E#16 is provided with one PSU 11 and one dummy unit 13 as a basic configuration as described above. When E#6 having the PSU 11 and the dummy unit 13 is added to the rack 500b, a work is performed according to the following sequence (1) to (5). Also, the following sequence is performed in the activated state of the server system 1.

(1) E#16 is inserted into the slot adjacent to the upper side of E#15 of the rack 500b. Accordingly, E#16 is disposed at the upper-most end in the rack 500b. (2) The dummy unit 13 is removed from E#16. (3) One PSU 11 is removed from E#15. (4) The PSU 11 removed from E#15 is attached to E#16. Accordingly, E#16 is provided with two PSUs 11 and is made redundant.

(5) The dummy unit 13 removed from E#16 is attached to E#15. Accordingly, E#16 disposed at the upper-most end and E#10 disposed at the lower-most end in the rack 500b have redundant PSUs 11.

### (B) Inter-case Connection Mechanism

The connection mechanism between cases 200 will be made.

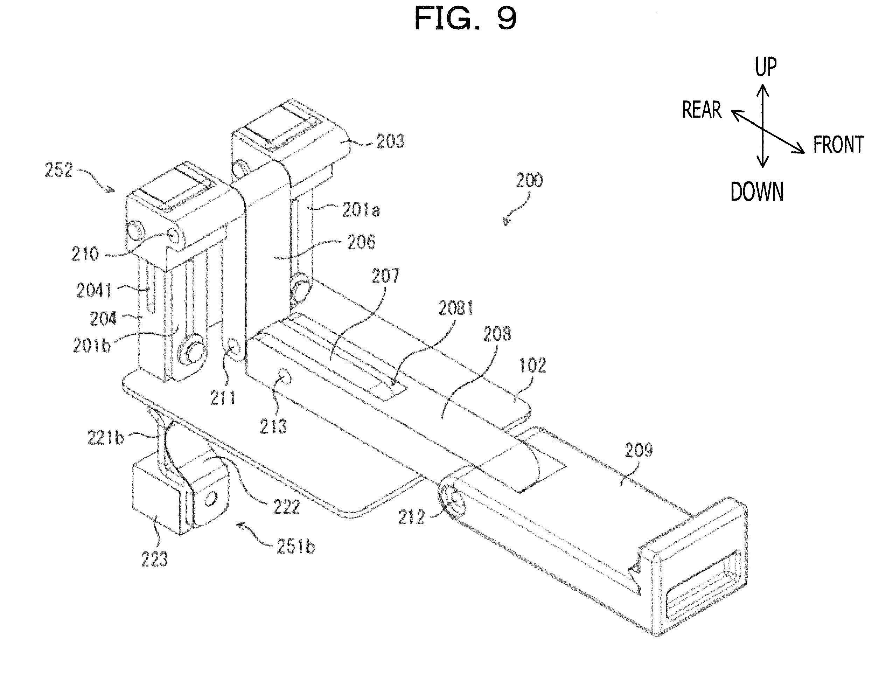

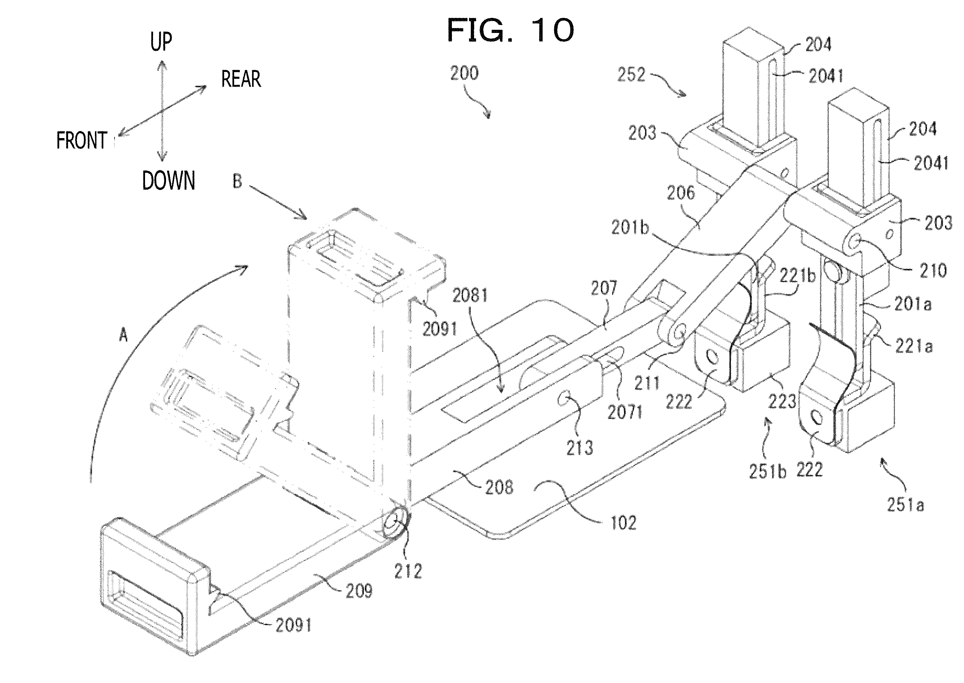

The inter-case connection mechanisms are provided within the case 101 of each electronic device 10 to connect the electronic device 10 with another electronic device 10 adjacent thereto. FIG. 8 is a partial perspective view illustrating the inter-case connection mechanisms 200 in the electronic devices 10 of the server system 1 as an example of the exemplary embodiment. Also, FIGS. 9 and 10 are perspective views illustrating a configuration of the inter-connection mechanism 200. FIG. 9 illustrates the inter-connection mechanism 200 in a state where the adjacent electronic devices 10 are not coupled and FIG. 10 illustrates the inter-connection mechanism 200 is a state in which the adjacent electronic devices 10 are coupled.

The inter-case connection mechanism 200 is provided with a movable connection unit 252 and fixed connection units 251a, 251b. The fixed connection units 251a, 251b are fixed side by side on a side surface of the MP 12 (front surface in an example illustrated in FIG. 8) in the vicinity of the surface (top surface in the present exemplary embodiment) of the case 101 adjacent to the other electronic device 10 which is adjacent to the above-described electronic device 10.

The fixed connection unit 251a is provided with a connection bus bar 221a and a leaf spring 222. The connection bus bar 221a is a conductive plate-shaped member coupled to a GND line of the MP 12 and fixed substantially parallelly to the MP 12 through a spacer 223. The leaf spring 222 is installed to be opposed to the connection bus bar 221a and biased to come into contact with the connection bus bar 221a.

The movable bus bar 201a of the movable connection unit 252 of the other electronic device 10 adjacent to the above-described electronic device 10 is inserted between the connection bus bar 221a and the leaf spring 222. Accordingly, the connection bus bar 221a and the movable bus bar 201a are electrically coupled. That is, the fixed connection unit 251a connects the GND line to the other electronic device 10 adjacent to the above-described electronic device 10 by the connection to the movable bus bar 201a of the movable connection unit 252 of the other adjacent electronic device 10.

Also, the connection bus bar 221a and the leaf spring 222 are curved in such a manner that the end surfaces thereof are to be spaced away from each other. Accordingly, the movable bus bar 201a may be easily inserted between the connection bus bar 221a and the leaf spring 222.

The fixed connection unit 251b is provided with a connection bus bar 221b and the leaf spring 222. The connection bus bar 221b is a conductive plate-shaped member coupled to a 12V line of the MP 12 and fixed substantially in parallel to the MP 12 through the spacer 223. The leaf spring 222 is installed to be opposed to the connection bus bar 221b and biased to come into contact with the connection bus bar 221b.

The movable bus bar 201b of the movable connection unit 252 of the other electronic device 10 adjacent to the above-described electronic device 10 is inserted between the connection bus bar 221b and the leaf spring 222. Accordingly, the connection bus bar 221b and the movable bus bar 201b are electrically coupled. That is, the fixed connection unit 251b connects the 12V line to the other electronic device 10 adjacent to the above-described electronic device 10 by the connection to the movable bus bar 201b of the movable connection unit 252 of the other adjacent electronic device 10.

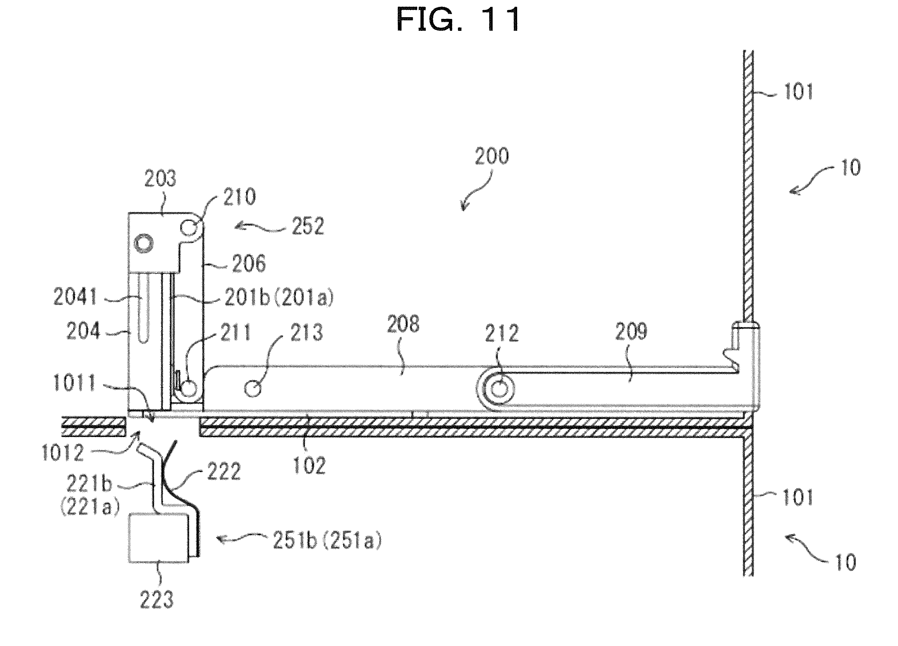

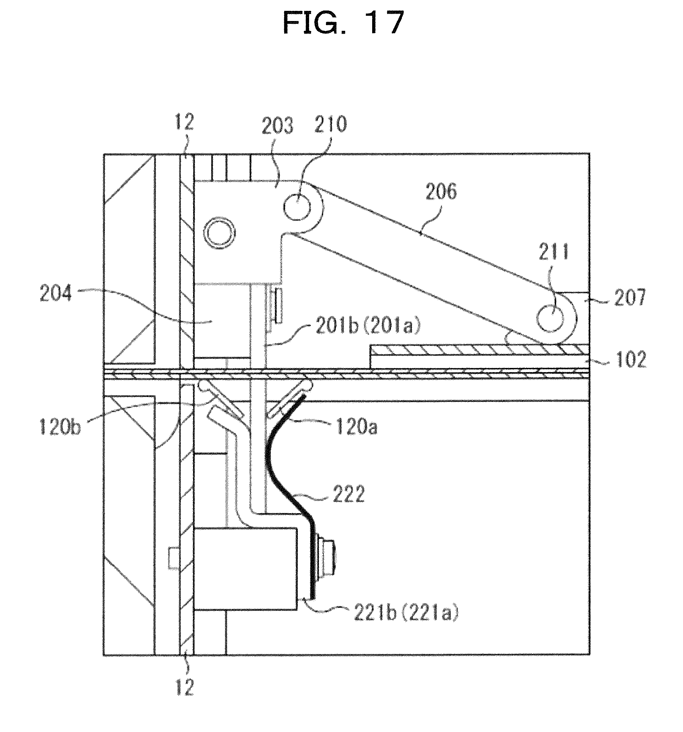

Also, in the fixed connection unit 251b, the end surfaces of the connection bus bar 221b and the leaf spring 222 at the upper side of the case 101 are curved to be spaced away from each other. Accordingly, the movable bus bar 201b may be easily inserted between the connection bus bar 221b and the leaf spring 222. Also, upper openings (second openings) 1012, 1012 are formed at upper locations of the fixed connection units 251a, 251b of the case 101, respectively (see, *e.g*., FIGS. 2 and 11). In addition, these upper openings 1012, 1012 are provided with covers 120a, 120b which are a side-by-side doortype, respectively (see, *e.g*., FIG. 17). These covers 120a, 120b are biased by an elastic member such as, e.g., a torsion spring (not illustrated) such that they close down the upper openings 1012 and the covers 120a, 120b are opened by pushing in the direction of entering into the case 101 from the upper side.

The movable connection unit (movable part) 252 causes the movable bus bars 201a, 201b to arbitrarily protrude toward the outside of the case 101. Specifically, the movable connection unit 252 causes the movable bus bars 201a, 201b to protrude from lower openings (first openings) 1011(see, *e.g*., FIG. 11.) formed on the bottom (lower part) of the case 101 underneath the case 101. Hereinafter, the underneath of the case 101 may be denoted as a protruding direction.

In one surface of the MP 12 (the front surface in the example illustrated in FIG. 8), the movable connection unit 252, is fixed at the side opposite to the above-described fixed connection units 251a, 251b of the case 101 in the vicinity of the surface (bottom surface in the present exemplary embodiment) adjacent to the other electronic device 10.

The movable connection unit 252 includes the movable bus bars 201a, 201b, bar holding units (holders) 203, rails 204, a movable jig 206, a connecting bar 204, a movable jig support 208, an operating lever 209, and shafts 210 to 212.

The rails 204 are installed in parallel along the vertical direction on the front surface of the MP 12. These rails 204 are formed with guiding grooves 2041 along the vertical direction, respectively. Protrusions (not illustrated) of the bus bar holding units 203 are inserted into the guiding grooves 2041, and slide in the vertical direction by being guided by the grooves 204a, respectively.

The bus bar holding units 203 hold the connection bus bars 221a, 221b and are guided by the rails 204 while holding the connection bus bars 221a, 221b, respectively, thereby moving the movable bus bars 201a, 201b in vertical direction. Also, as described above, the lower openings (the first openings) 1011 are formed at the lower side locations of the movable buses bars 201a, 201b the case 101, respectively (See, e.g., FIG. 11).

The bus bar holding units 203cause the movable bus bars 201a, 201b to protrude to the lower side of the case 101 from the lower openings 1011, 1011 and to be inserted into the fixed connection units 251 of the electronic device 10 adjacent thereto at the lower side. Also, the bus bar holding units 203 are coupled by the shaft 210 extending therethrough in the horizontal direction. Accordingly, the movable bus bar 201a and the movable bus bar 201b move together.

Each of the movable bus bar 201b and the movable bus bar 201a is a conductive board-shaped member. The movable bus bar 201a is coupled to the GND of the MP 12 and the movable bus bar 201b is coupled to the 12V line of the MP 12. The power supplied from the movable bus bars 201a, 201b or the connection bus bars 221a, 221b is diode-OR-coupled to the power supplied from the PSU 11 which is provided in the above-described electronic device 10 on the MP 12.

Also, the movable bus bar 201a is formed to be longer than the movable bus bar 201b, protruding to the lower side farther than the movable bus bar 201b. Accordingly, when the movable bus bars 201a, 201b are moved to the lower side by the bus bar holding units 203, the movable bus bar 201a is inserted into and coupled with the fixed connection unit 251 earlier than the movable bus bar 201b. That is, between the electronic device 1, the GND line is coupled earlier than the 12V line.

Likewise, when the movable bus bars 201a, 201b are moved to the upper side by the bus bar holding unit 203 in a state in which each of the movable bus bars 201a, 201b is coupled to the fixed connection unit 251, the movable bus bar 201a is pulled out from the fixed connection unit 251 later than the movable bus bar 201b. That is, in the electronic device 10, the GND line is cut later than the 12V line.

The shaft 210 configured to connect through the bus bars holding units 203 also penetrates an end portion of the movable jig 206 between the bus bar holding units 203, 203, thereby pivotally supporting the end portion of the movable jig 206. The movable jig support 208 is guided by a guide (not illustrated) to be slid back and forth along the bottom surface of the case 101. At the front side end portion of the movable jig support 208, the operating lever 209 is attached to be rotatable through the shaft 212. An operator moves the movable jig support 208 back and forth by moving the operating lever 209 back and forth.

The movable jig support 208 and the movable jig 206 are coupled by a connecting bar 207. The end portion of the movable jig 206 opposite to the side pivotally supported by the shaft 210 is pivotally supported at one end portion (back side end portion) of the connecting bar 207 by the shaft 211. The movable jig support 208 is formed with a recess 2081 toward the extending direction (front side) of the movable jig support 208 in a shape which is substantially the same as appearance of the connecting bar 207 at the back side end portion of the movable jig support 208 and the other end portion (front side end portion) of the connecting bar 207 is disposed within the recess 2081.

The connecting bar 207 is formed with a guide hole 2071 which is communicated in the extending direction of the shaft 211 and extends from the other end portion of the connecting bar 207 throughout the back side of the connecting bar 207 and the back side end portion of the movable jig support 208 is coupled to the guide hole 2071 by the penetrated pin 213. The back side end portion of the pin 213 and the movable jig support 203 are configured to be guided in the guide hole 2071 to be slidable back and forth. Accordingly, the movable jig support 208 and the movable jig 206 are telescopically coupled by the connecting bar 207.

Also, a connection unit bottom cover 102 is fixed to the bottom side of the movable jig support 208. The connection unit bottom cover 102 is a cover which opens/closes the lower openings 1011 formed on the lower part (bottom) to open/close the lower opening 1011 according to the back and forth movement of the movable jig support 208. The connection unit bottom cover 102 covers and hides (closes down) the lower openings 1011 in a state in which the movable jig support 208 is located at the rear-most side and opens the lower opening 1011 in a state in which the movable jig support 208 is moved to the front side.

As described above, the operating lever 209 is rotatably attached to the front side end portion of the movable jig support 208 through the shaft 212. The operator rotates the operating lever 209 about the shaft 212 to be unfolded to a linear shape and then moves the operating lever 209 forth or back. In addition, it is preferable that the movable jig 206, the connecting bar 207, the bus bar holding unit 203, the movable jig support 208, the operating lever 209 and connection unit bottom cover 102 as described above are formed of an anti-static processed insulator.

Hereinafter, the operator's operation of moving the operating lever 209 to the front may be referred to as draw-out of the operating lever 209 and the operator's operation of moving the operating lever 209 to the rear side is denoted as press-in of the operating lever 209. Each of the movable jig 206, the connecting bar 207 and the movable jig support 208 as described above is pivotally supported to the operating lever 209 at one end and is pivotally supported to the bus bar holding unit 203 at the other end. Therefore, the movable jig 206, the connecting bar 207 and the movable jig support 208 serve as a connecting part which connect the operating lever 209 and the bus bar holding unit 203. This connecting part coverts the back and forth movement of the operating lever 209 to the vertical (protruding direction) movement of the bus bar holding unit 203 (movable bus bars 201a, 201b).

Also, as illustrated in FIG. 10, the operating lever 209 is rotated upwardly about the shaft 212 (see arrow A in FIG. 10.) in a state in which it is moved to the front-most side, that is, in the drawn state, thereby being folded in a vertical state (see arrow B in FIG. 10). In response to the press-in operation and the draw-out operation of the operating lever 209, the movable bus bars 201a, 201b move in and out of the lower openings 1011 of the case 101 and moves out and in of the inside of the case 101 of the electronic device 10 which is located under the above-described electronic device 10 through the upper openings 1012 formed on the upper part of the case 101.

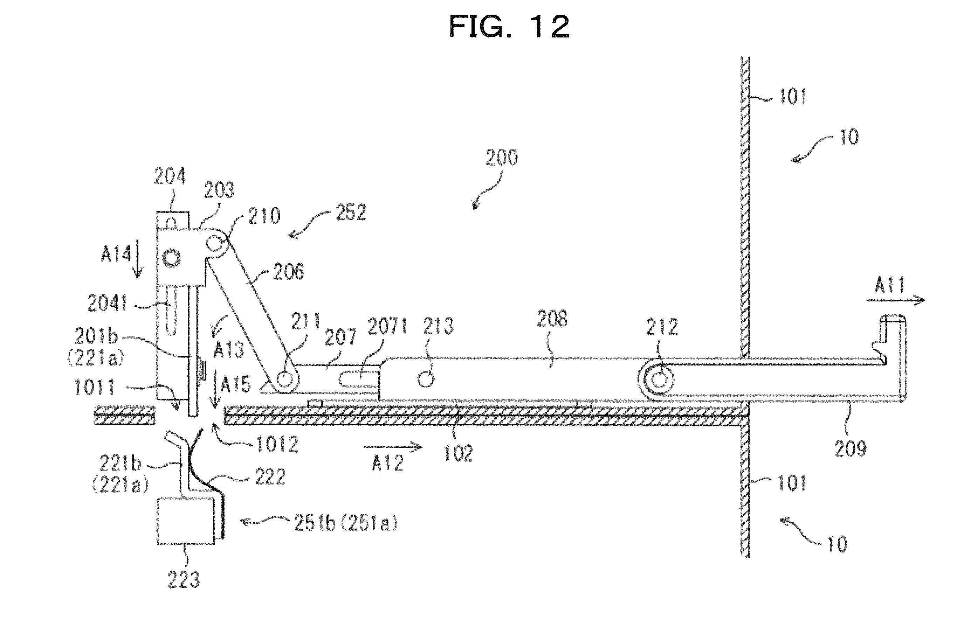

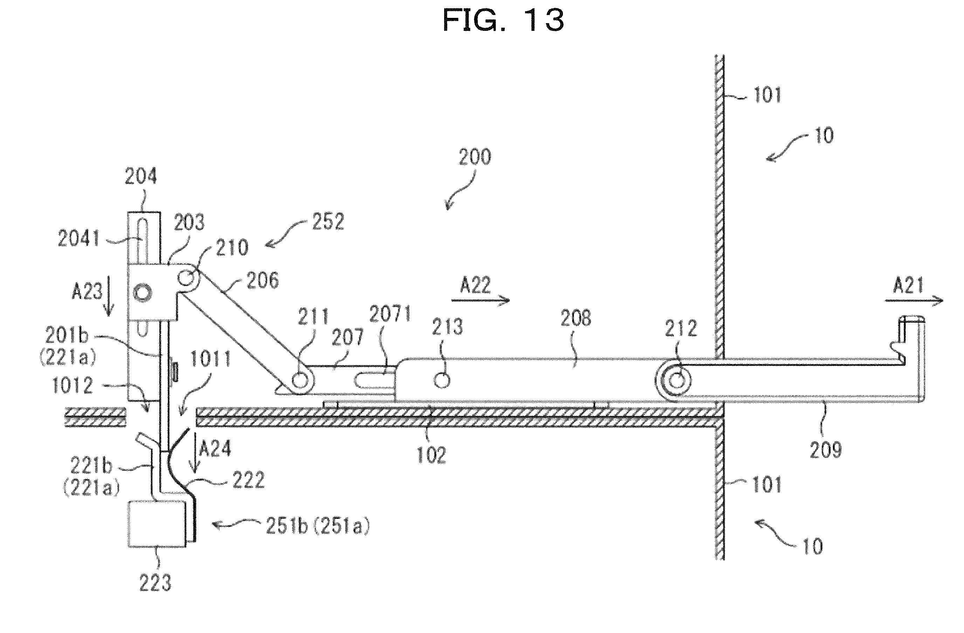

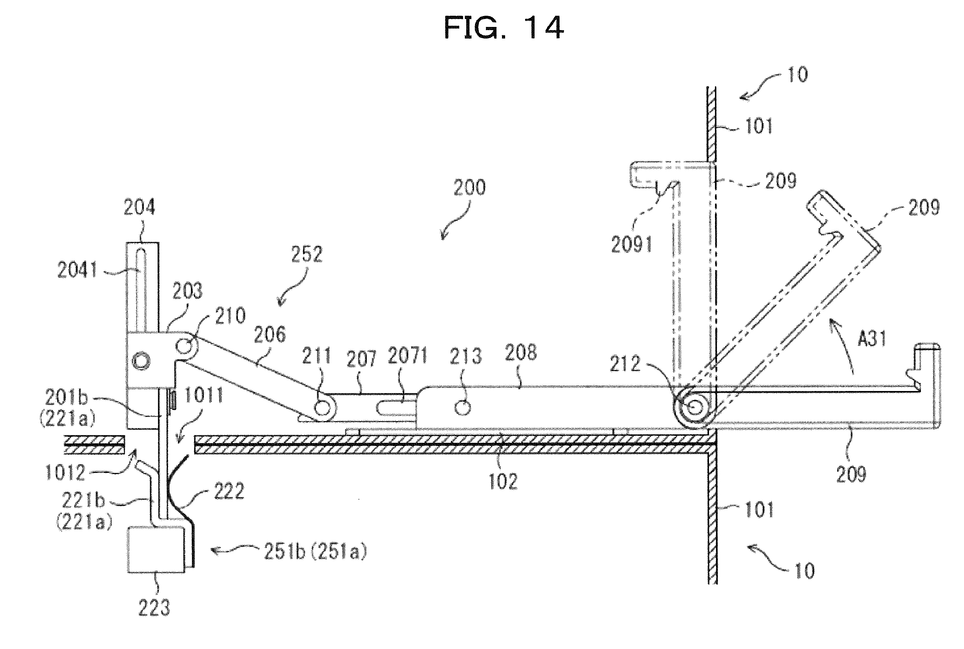

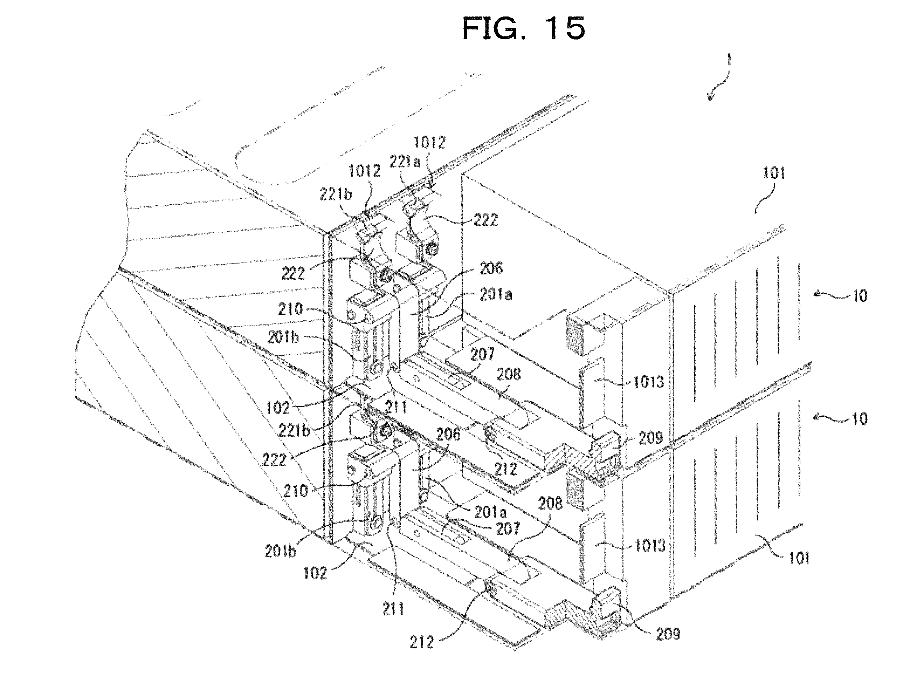

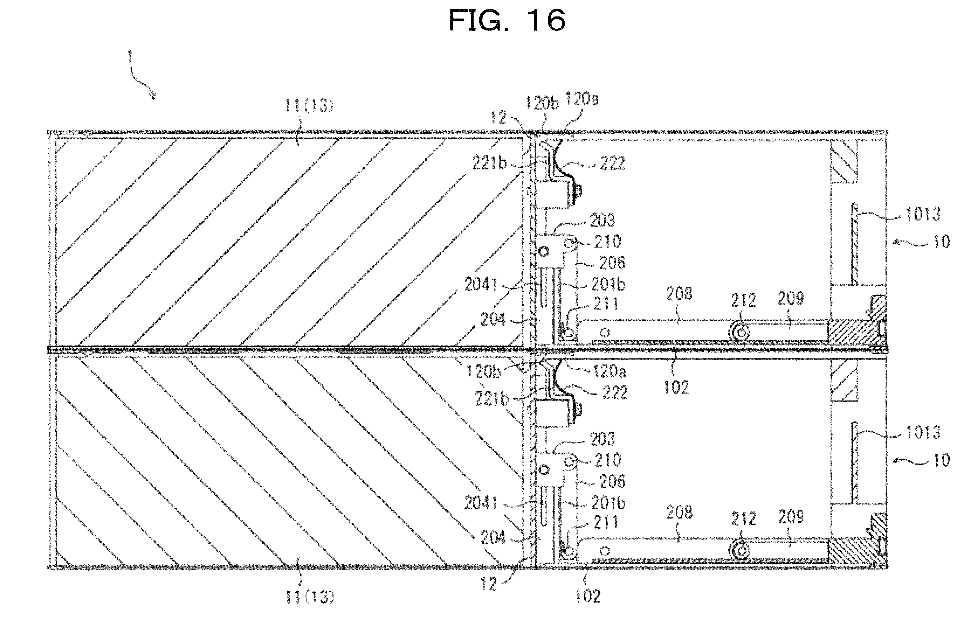

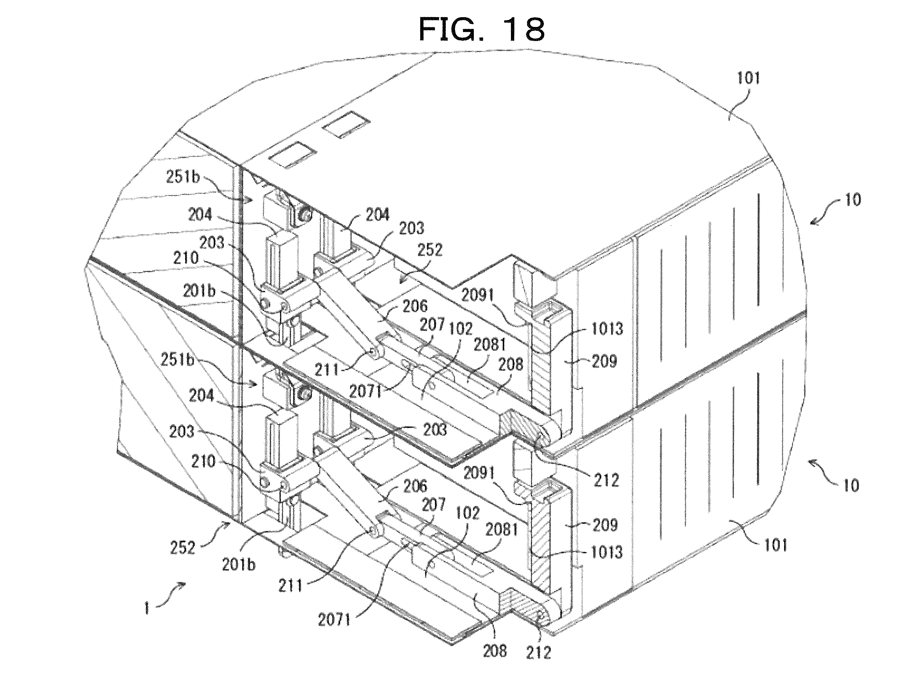

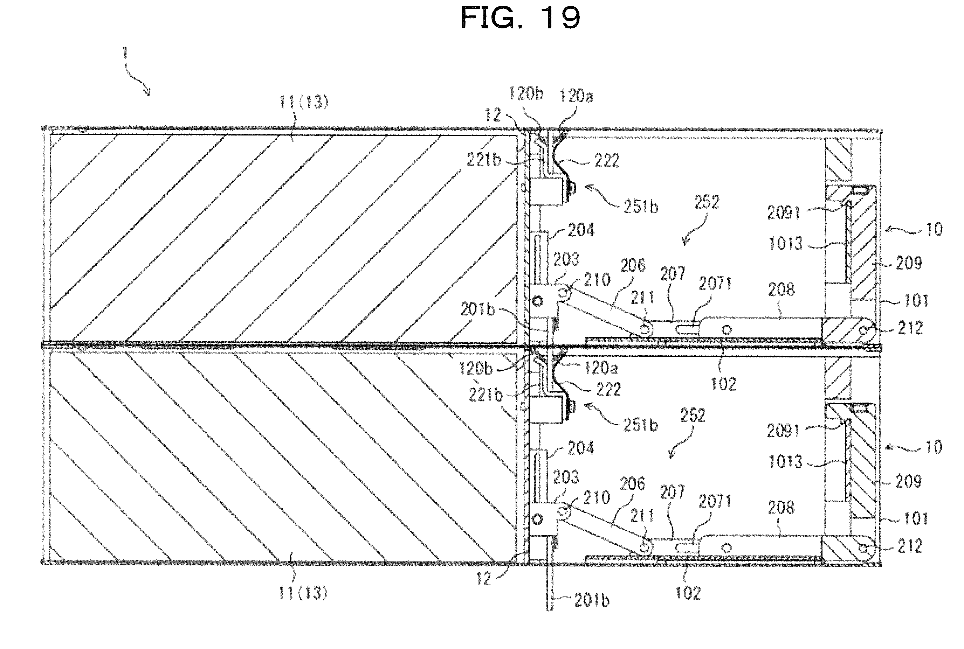

Further, it is preferable that these lower openings 1011 and upper openings 1012 are formed of an antistatic processed insulator or covered with an insulator. FIGS. 11 to 14 are side views of the inter-case connection mechanism 200 of the server system 1 according to the exemplary embodiment respectively. FIG. 11 is a view illustrating an operating lever 209 in a pressed-in state, that is, in a state where the operating lever 209 is not drawn, FIGS. 12 and 13 are views illustrating the operating lever 209 in the course of being drawn out, and FIG. 14 is a view illustrating the operating lever 209 in the drawn-out state. Also, FIG. 15 is a perspective view illustrating a portion of electronic devices 10 in a state in which operating levers 209 are not drawn out and FIG. 16 is a side view of FIG. 15. FIG. 17 is a view illustrating a configuration in the vicinity of a lower opening 1011 in FIG. 14 in detail. FIG. 18 is a perspective view illustrating a portion of the electronic devices 10 in a state in which the operating levers 209 illustrated in FIG. 14 are drawn out and FIG. 19 is a side view of FIG. 18.

Referring to these drawings, a connection method between electronic devices 10 by the inter-case connection mechanism 200 in the server system 1 will be described as an example of the present exemplary embodiment. The examples illustrated in FIGS. 11, 15, and 16 illustrate a state in which, for example, just after an electronic device 10 has been inserted into the rack 500, this electronic device 10 is not coupled to another electronic device located below the electronic device in the rack 500.

As illustrated in these FIGS. 11, 15, and 16, in a state in which the operating lever 209 is not drawn out, the movable jig 206 stands erect in a state where its end portion at the side where it is coupled to the connecting bar 207 through the shaft 211 is directed downward. Accordingly, the bus bar holding unit 203 attached to the other end of the movable jig 206 through the shaft 210 is maintained in a raised state along the rail 204. That is, the movable bus bars 201a, 201b held by the bus bar holding units 203, 203 are raised and maintained in the state where the movable bus bars 201a, 201b are accommodated state within the case 101.

Also, at this time, the connection unit bottom cover 102 fixed to the movable jig support 208 is disposed at the location where it covers and closes the lower openings 1011 formed on the bottom of the case 101. Accordingly, it may be prevented that for example, an operator mistakenly touches the movable bus bars 210a, 201b via the lower openings 1011. As illustrated in FIG. 12, when an operator draws out the operating lever 209 a little bit (see arrow A11), the movable jig 208 is moved forward according to the draw-out of the operating lever 209 (see arrow A12). Further, the connecting bar 207 is also moved forward as the forward movement of the movable jig support 208 and the lower end portion of the movable jig 206 coupled by the shaft 211 also moves forward.

According to the movement of the movable jig support 208, the connection unit bottom cover 102 fixed to the moving jib support 208 also moves forward on the lower opening 1011. The movable jig 206 serves as a crank type and rotates around the shaft 211 according to the forward movement of the shaft 211 side end portion thereof (see arrow A13). The movement of the bus bar holding unit 203 which is coupled to the other end of the movable jig 206 through the shaft 210 is limited to vertical direction. Accordingly, the shaft 210 side end portion of the movable jig 206 and the bus bar holding unit 203 are moved downwardly along the rail 204 (see arrow A14).

When the bus bar holding unit 203 is moved downward along the rail 204 the movable bus bar 201a (201b) fixed to the bus bar holding unit 203 is also moved downward and protrude from the lower opening 1011 from which the connection unit bottom cover 102 is retracted (see arrow A15).

As illustrate in FIG. 13, when the operator further draws out the operating lever 209 (see arrow 21), the movable jig support 208 is moved forward according to the draw-out of the operating lever 209 (see arrow 22). In addition, according to the forward movement of the movable jig support 208, the lower end portions of the connecting bar 207 and the movable jig 206 are moved forward. Accordingly, the bus bar holding unit 203 is moved downward along the rail 204 (see arrow A23) and movable bus bar 201a (201b) fixed to the bus bar holding unit 203 is also moved downward, thereby reaching the fixed connection unit 251 of the electronic device 10 at the lower side through the lower opening 1011 and the upper opening 1012.

Thereafter, when the operator further draws out the operating lever 209, as illustrated in FIG. 14, the movable bus bars 201a (201b) fixed to the bus bar holding unit 203 is inserted between the connection bus bar 221a (221b) and the leaf spring 222. Accordingly, the connection bar 221b and the movable bus bar 201b are electrically coupled with each other.

The connection bus bar 221a (221b) and the movable bus bar 201a (201b) are engaged with each other, as illustrated in FIG. 17. As illustrated in FIG. 17, the movable bus bar 201a (201b) pushes and opens top cover 120a, 120b, then enter into the case 101 of the electronic device 10 at the lower side, and further advances between the connection bus bar 221a (221b) and the leaf spring 222 of the fixed connection unit 251.

In the fixed connection unit 251, the leaf spring 222 urges the movable bus bar 201a (201b) against the connection bus bar 221a (221b), thereby connecting the movable bus bar 201a (201b) and the connection bus bars 221a (221b) securely. In this manner, in the rack 500a (500b), the movable bus bar (first connection terminal) 201a (201b) of an electronic device 10 accommodated in the upper end is coupled to the connection bus bar (second connection terminal) 221a (221b) of the fixed connection unit 251a (251b) of an electronic device 10 accommodated in the lower end through the lower opening 1011 and upper opening 1012 formed in the case 101. Accordingly, the electronic device 10 accommodated in the upper section and the electronic device 10 accommodated in the lower end are electrically coupled.

Also, as for three and more electronic devices 10 (for example, electronic devices 10-0, 10-1, 10-3 of FIG. 1) disposed side by side in the vertical direction within the rack 500, the movable bus bars 201a, 201b of the electronic device 10-1 disposed in the middle serve as first connection terminals. That is, the movable bus bars 201a, 201b are disposed to be opposed to the connection bus bars 221a, 221b (third power exchange terminals) of the third electronic device 10-0 and engaged with the connection bus bars 221a, 221b, thereby exchanging power.

Also, the connection bus bars 221a, 221b of the electronic device 10-1 serve as second connection terminals. That is, the connection bus bars 221a, 221b are disposed to be opposed to the movable bus bars 201a, 201b (the first power exchange terminals) of the first electronic device 10-2 and perform power exchange by being engaged with the movable bus bars 201a, 201b.

The operator rotates the operating lever 209 protruding forward from the case 101 about the shaft 212 to be in the vertical position (see arrow A31 of FIG. 14). The operating lever 209 in the vertical position locks, for example, a protrusion 2091 to an engaging unit 1013 formed on the case 101 (see, e.g., FIGS. 15 and 19).

### (C) Effect

As described above, according to the server system 1 as an example of an exemplary embodiment, the power lines of the plurality of electronic devices 10 disposed in the vertical direction or the horizontal direction within a rack 500 are coupled by inter-case connection mechanisms 200. In addition, some of the electronic devices 10 are provided with redundant PSUs 11.

Accordingly, power may be shared by the electronic devices 10, 10, ..., 10 within the rack 500. That is, when a PSU 11 of any one electronic device 10 is broken down, the plurality of electronic devices 10 coupled by the inter-case connection mechanisms 200 adjust the current balance sequentially and resolve the entire imbalance of current of the server system 1. Accordingly, stable power may be supplied to all the electronic devices 10 including the electronic device 10 including the broken-down PSU 11.

Also, in the racks 500a, 500b, each of the electronic devices 10, 10 disposed at the upper-most and lower-most ends are provided with two PSUs 11. Accordingly, even when one electronic device 10 attached between the upper-most and lower-most ends is removed from the racks 500a, 500b, for example, for maintenance activities, the power of the PSUs 11 provided redundantly to the electronic devices 10 of the upper-most end or the lower-most end may be supplied to each of the remaining electronic devices 10 via the inter-case connection mechanisms 200. Therefore, each electronic device 10 may be stably operated.

In the server system 1, the power supplied by the PSU 11 installed in each electronic device 10 may be shared by each electronic device 10, when the break-down of PSUs 11 in some of the electronic devices 10 occurs, broken-down electronic devices 10 may be continuously operated, thereby enhancing the reliability. Also, electronic devices 10 may be easily coupled by providing inter-case connection mechanisms 200 configured to cause movable bus bars 201a, 201b to protrude and to be electrically coupled with fixed connection bars 251 of another electronic device. Further, since the electronic devices 10 may be coupled without using, for example, a cable for power supply, work efficiency of installing of the electronic devices 10 on the rack 500 or removing the electronic device from the rack 500 may be enhanced and the current efficiency does not deteriorate.

Each of the electronic devices 10 may be made to be redundant by providing two PSUs 11 for each of the electronic devices 10 disposed at the upper-most and lower-most ends in the racks 500a, 500b and providing one PSU and one dummy unit 13 for the electronic devices 10 disposed in the middle. Therefore, the installation number of the PSUs 11 may be reduced, thereby reducing the costs for devices.

Also, by reducing the installation number of the PSUs 11, power consumption may be reduced. The operator may perform an operation of inserting/drawing-out movable bus bars 201a, 201b into/from fixed connection bars 251a, 251b in the outside of a case by performing an operation of press-in/draw-out of an operating lever 209 in relation to the case 101. The operating lever 209 protruding forward from the case 101 may be brought into the vertical position by rotating about the shaft 212. Also, the protrusion 2091 of the operating lever 209 may be locked to the engaging unit 1013 (see FIGS. 15 and 19) formed in the case 101. Accordingly, the operating lever 209 protruding from the case 101 is not pressed into the case 101 in the operator's unintended situation, thereby enhancing the reliability.

### (D) Modified Example

Regardless of the above-described exemplary embodiments, various changes may be made without departing the intent of the exemplary embodiments. For example, in the above-described exemplary embodiments, as illustrated, for example, in FIG. 1, although a single external power supply path 2 is provided, the exemplary embodiments are not limited thereto. The external power supply path 2 may be made to be redundant.

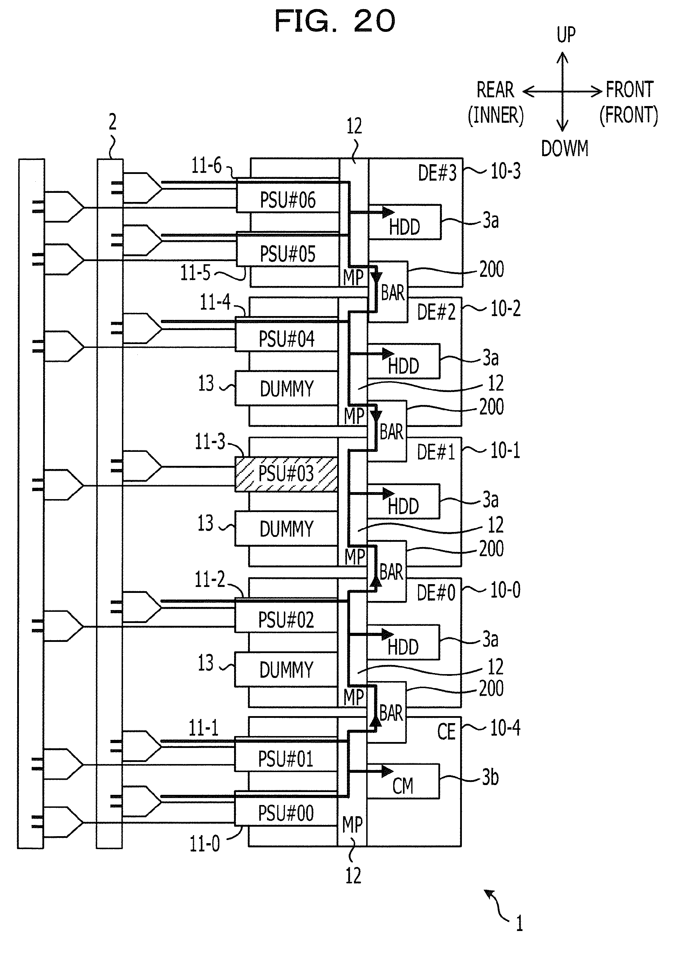

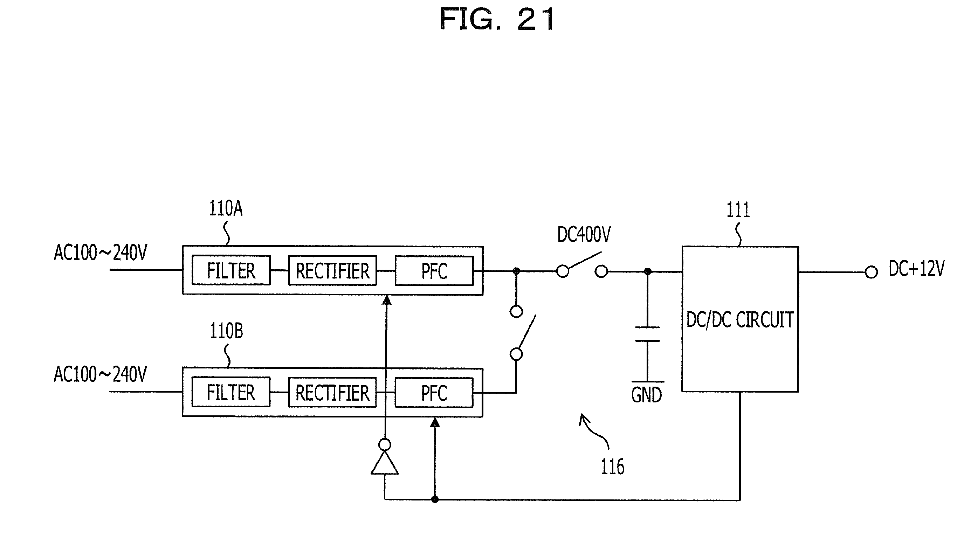

FIG. 20 is a view illustrating a modified example of the configuration of the server system 1 as an example of the exemplary embodiment and FIG. 21 is a view illustrating an arrangement of the PSUs 11. Hereinafter, in the drawings, since the symbols which are the same as the previously described symbols denote the same parts, the descriptions thereof will be omitted. In the example illustrated in FIG. 20, instead of the single external power supply path 2 in the server system 1 illustrated in FIG.1, two external power supply paths 2A, 2B are provided. The external power supply paths 2A, 2B are both, for example, AC100V to 240V (external power).

As illustrated in FIG. 21, a PSU 11 is provided with a plurality of AC/DC conversion circuits 110A, 110B depending on the external power supply paths 2A, 2B and also provided the DC/DC circuit 111 and a switch circuit 116. Also, in the example illustrated in FIG. 21, the AC/DC conversion circuits 110A, 110B are provided with a filter circuit 1101, a rectifier circuit 1102, a PFC (Power Factor Correction) circuit.

For example, in a normal operation, DC power is supplied through the AC/DC conversion circuit with the power supply from a single external power supply path 2A. When the DC/DC circuit 111 detects that the power supply from the external power supply path 2A is stopped, the DC/DC circuit 111 instructs a power supply notice to the AC/DC conversion circuit 110B at the other side and switches the switch circuit 116 to perform the supply of DC power based on the power supply from the external power supply path 2B at the other side. Accordingly, continuous power supply may be implemented in the server system 1.

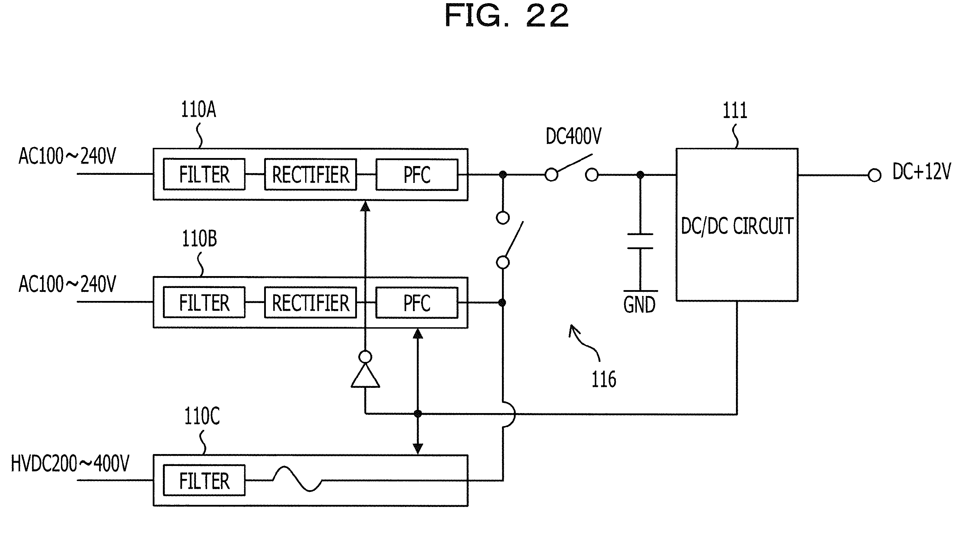

Also, although the power supply is performed in the two same kinds of external power supply paths 2A, 2B in the examples illustrated in FIGS. 20 and 21, it is not limited thereto. That is, power supply may be performed from plural kinds of external power supply paths 2. FIG. 22 is a view illustrating a configuration of a PSU 11 in another modified example of the configuration of the server system 1 as an example of an exemplary embodiment.

In the example illustrated in FIG. 22, the power supply (200 to 400V) from a HVDC (High-Voltage, Direct Current) is performed in addition to ther two external power supply paths 2A, 2B illustrated in FIGS. 20 and 21. Similarly to this, the external power supply path 2 is not limited to the conventional AC power and may be multiplexed by connecting the HVDC power. Likewise, redundant external power supply paths are provided and power supply to each PSU is performed through the plurality of external power supply paths. Accordingly, even when an obstacle occurs in one external power supply path, power supply may be performed from the other external power supply path. Therefore, the operation may be continued and the reliability may be enhanced. For example, if the server system 1 is a storage system, the reliability may be enhanced in view of the data preservation.

Further, in the above-described exemplary embodiments, although each of the electronic devices 10 disposed at the upper-most and lower-most ends is provided with two PSUs 11 and each of the electronic devices 10 disposed in the middle is provided with a single PSU 11 and a dummy unit 103, it is not limited thereto. By increasing the number of the PSUs 11 installed in the server system 1, redundancy may be further increased and a flexible operation may be implemented.

Furthermore, although the server system 1 in which a plurality of electronic devices 10 disposed side by side within the rack 500 is illustrated in the above-described exemplary embodiment and the modified examples, it is not limited thereto. For example, the present disclosure may be applied to a system in which a plurality of electronic devices disposed side by side in a predetermined direction and adjacent to each other to supply power to each other. Also, the exemplary embodiments of the present disclosure may be implemented and manufactured by a person skilled in the art.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the spirit and scope of the invention.

## Claims

1. An electronic device comprising:
a power supply line configured to supply power to a mechanical section within a case; and
a connection terminal coupled to the power supply line,
wherein the connection terminal is disposed to be opposed to a power exchange terminal of another electronic device disposed on one side surface of the case and engaged with the power exchange terminal to perform a power exchange.

2. The electronic device according to claim 1, further comprising:
a movable unit configured to cause the connection terminal to protrude to the outside through a first opening provided in the case,
wherein the connection terminal is caused to protrude to the outside through the first opening by the movable unit and electrically coupled with the power exchange terminal of the electronic device disposed on the one side surface.

3. The electronic device according to claim 2, wherein the connection terminal includes:
an operating lever configured to be moved in a direction orthogonal to the protruding direction of the connection terminal;
a rail installed along the protruding direction of the connection terminal;
a holding unit configured to be guided on the rail in the protruding direction in a state where the connection terminal is held in the holding unit; and
a connecting unit including one end pivotally supported in the operating lever and the other end pivotally supported in the holding unit to connect the operating lever and the holding unit.

4. An electronic device comprising:
a power supply line configured to supply power to a mechanical section within a case;
a first connection terminal coupled to the power supply line, the first connection terminal being disposed to be opposed to a first power exchange terminal of a first electronic device disposed on one side surface of the case and engaged with the first power exchange terminal to perform a power exchange; and
a second connection terminal coupled to the power supply line, the second connection terminal being disposed to be opposed to a second power exchange terminal of a second electronic device disposed on another surface opposite to the one side surface of the case and engaged with the second power exchange terminal to perform the power exchange.

5. The electronic device according to claim 4, further comprising:
a movable unit configured to cause the first connection terminal to protrude to the outside through a first opening provided to the case,
wherein the first connection terminal is caused to protrude to the outside through the first opening by the movable unit and electrically coupled with the first power exchange terminal of the first electronic device, and
the second connection terminal is electrically coupled with the second power exchange terminal of the second electronic device inserted through a second opening provided on the another surface of the case.

6. The electronic device according to claim 1, further comprising:
a power supply unit disposed within the case and configured to supply power to the mechanical section through the power supply line.

7. The electronic device according to claim 1, further comprising:
an adjusting unit configured to adjust the power supplied to the mechanical section to a predetermined value.

8. An electronic device system comprising:
a plurality of electronic devices including a first electronic device, a second electronic device, and a third electronic device disposed side by side in a predetermined direction,
wherein the first electronic device is provided with a first power exchange terminal coupled to a power supply line within the first electronic device,
the third electronic device is provided with a third power exchange terminal coupled to a power supply line within the third electronic device, and
the second electronic device includes:
a first connection terminal coupled to a power supply line within the second electronic device, the first connection terminal being disposed to be opposed to the first power exchange terminal of the first electronic device and engaged with the first power exchange terminal to perform a power exchange, and
a second connection terminal coupled to the power supply line within the second electronic device, the second connection terminal being disposed to be opposed to the third power exchange terminal of the third electronic device and engaged with the third power exchange terminal to perform the power exchange.

9. The electronic device system according to claim 8, further comprising:
a movable unit configured to cause the first connection terminal to protrude to the outside through a first opening provided to the case,
wherein the first connection terminal is caused to protrude to the outside through the first opening by the movable unit and electrically coupled with the first power exchange terminal of the first electronic device, and
the second connection terminal is electrically coupled with the second power exchange terminal of the second electronic device inserted through a second opening provided on the another surface of the case.

10. The electronic device system according to claim 9, wherein the connection terminal includes:
an operating lever configured to be moved in a direction orthogonal to the protruding direction of the first connection terminal;
a rail installed along the protruding direction of the first connection terminal;
a holding unit configured to be guided on the rail in the protruding direction in a state where the first connection terminal is held in the holding unit; and
a connecting unit including one end pivotally supported in the operating lever and the other end pivotally supported in the holding unit to connect the operating lever and the holding unit.

11. The electronic device system according to claim 8, further comprising:
a power supply unit disposed within the case and configured to supply power to the mechanical section through the power supply line.

12. The electronic device system according to claim 11, further comprising:
an adjustment unit configured to adjust power to be supplied to the mechanical section to a predetermined value.

13. The electronic device system according to claim 11,
wherein each of the electronic devices disposed at opposite ends among the plurality of electronic devices is provided with a plurality of power supply units and each of the electronic devices disposed between the opposite ends are provided with a single power supply unit.
